(19) Europäisches Patentamt
European Patent Office
Office européen des brevets

(11) Veröffentlichungsnummer : **0 119 959**
**B1**

(12) # EUROPÄISCHE PATENTSCHRIFT

(45) Veröffentlichungstag der Patentschrift : **30.12.86**

(51) Int. Cl.$^4$ : **G 03 C 1/68**, G 03 F 7/10

(21) Anmeldenummer : **84810119.2**

(22) Anmeldetag : **12.03.84**

(54) **Verfahren zur Bilderzeugung.**

(30) Priorität : **16.03.83 GB 8307220**

(43) Veröffentlichungstag der Anmeldung : **26.09.84 Patentblatt 84/39**

(45) Bekanntmachung des Hinweises auf die Patenterteilung : **30.12.86 Patentblatt 86/52**

(84) Benannte Vertragsstaaten : **BE CH DE FR GB IT LI NL SE**

(56) Entgegenhaltungen :
**EP-A- 0 049 940**
**US-A- 3 450 613**
**US-A- 4 352 723**
**US-A- 4 358 477**

(73) Patentinhaber : **CIBA-GEIGY AG**
**Klybeckstrasse 141**
**CH-4002 Basel (CH)**

(72) Erfinder : **Irving, Edward, Dr.**
**41, Swaffham Road**
**Burwell Cambridge CB5 OAN (GB)**
Erfinder : **Smith, Terence James**
**6A Dickasons**
**Melbourn Royston Hertfordshire SG8 6EL (GB)**

**EP 0 119 959 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein neues Verfahren zur Bilderzeugung durch Erhitzen und anschliessender Bestrahlung mit aktinischem Licht.

Die Bilderzeugung mittels Photopolymerisation wird im allgemeinen so vorgenommen, dass man eine Unterlage mit einer Lösung einer photopolymerisierbaren Substanz in einem flüchtigen organischen Lösungsmittel beschichtet, das Lösungsmittel verdampft oder verdunsten lässt, wobei ein Film der photopolymerisierbaren Substanz gebildet wird, den Film durch ein Negativ mit aktinischem Licht bestrahlt und so die bestrahlten Stellen des Films photopolymerisiert (und weniger löslich macht), während die nicht belichteten Stellen im wesentlichen unverändert bleiben. Die nicht belichteten, nicht photopolymerisierten Stellen des Films werden mit einem geeigneten Lösungsmittel herausgelöst, das die belichteten photopolymerisierten Stellen des Films nicht auflöst. Diese letzte Stufe wird im allgemeinen « Entwickeln » genannt.

Wünschbar wäre ein Verfahren, bei dem ohne Verwendung von Lösungsmitteln eine Schicht aus photopolymerisierbarem Material in einem im wesentlichen festen, klebefreien Zustand auf eine Unterlage appliziert wird, wonach dann die Bestrahlung erfolgen kann. In dieser Phase könnte nicht nur auf die Verwendung von Lösungsmitteln, die bezüglich Toxizität und Entflammbarkeit problematisch sein können und deren Rückgewinnung aufwendig ist, verzichtet werden, sondern es würde auch die Herstellung von beschichteten, für die Bestrahlung bereiten Substraten in einem kontinuierlichen Verfahren erleichtert.

Es wurde gefunden, dass sich diese Aufgabe durch Verwendung bestimmter flüssiger Stoffzusammensetzungen, enthaltend zwei verschiedene Gruppen, an denen eine thermische Polymerisation und eine Vernetzung unter Lichteinfluss stattfinden können, lösen lässt. Diese zwei verschiedenen Gruppen können Bestandteil eines einzigen Moleküls sein oder in verschiedenen Molekülen vorliegen. Die Gruppen werden so gewählt, dass eine Schicht aus einem flüssigen Stoffgemisch durch thermische Polymerisation rasch in eine feste, im wesentlichen klebefreie Schicht übergeführt wird, die jedoch in bestimmten Lösungsmitteln noch löslich ist. Falls erwünscht, können Teile der Schicht mit aktinischem Licht bestrahlt werden, wobei über die andere Art der Gruppen in den schon thermisch polymerisierten Molekülen der Schicht eine Vernetzung unter Lichteinfluss erfolgt und die lichtvernetzten Stellen der Schicht in dem Lösungsmittel viel weniger löslich werden.

In der US-Patentschrift 4 291 118 ist ein Verfahren zur Herstellung von Reliefbildern aus einem Film aus flüssigem photopolymerisierbarem Material beschrieben. Dabei wird der Film bis zur Verfestigung einer thermischen Härtung unterzogen, und der verfestigte Film wird in einem bestimmten Muster, z. B. durch eine Photomaske, so behandelt, dass in dem verfestigten Film entsprechend dem Muster an den behandelten und nicht behandelten Stellen unterschiedliche chemische Zustände entstehen. Anschliessend wird selektiv der Teil der Masse in dem einen chemischen Zustand entfernt, wobei der Teil der Masse in dem anderen chemischen Zustand ein Reliefbild bildet. Um die unterschiedlichen chemischen Zustände zu erzeugen, wird in allen beschriebenen Ausführungsformen aktinisches Licht angewendet, obwohl in der Beschreibung angegeben wird, eine weitere Möglichkeit bestehe in der Anwendung von Wärme. Bei dem in dieser U.S. Patentschrift beschriebenen Verfahren wird somit der Film aus flüssigem Material mit aktinischem Licht bestrahlt, und der verfestigte Film wird dann erneut in einem vorgegebenen Muster mit aktinischem Licht bestrahlt, so dass ein Teil oder bestimmte Teile des Films sich weniger leicht durch Lösungsmittel entfernen lassen. Schliesslich wird das Bild entwickelt, indem man die leichter entfernbaren, d. h. die nicht ein zweites Mal bestrahlten Stellen, mit einem Lösungsmittel auswäscht. Die Bestrahlungsbedingungen müssen bei diesem Verfahren sehr genau kontrolliert werden. Bei ungenügender Bestrahlung in der ersten Stufe bleibt das verfestigte Material klebrig und unangenehm in der Handhabung. Wird es zuviel bestrahlt, so erhält man Bilder mit ungenügender Auflösung. Es wird nur die Verwendung von photopolymerisierbaren Polyen-Polythiol-Stoffgemischen beschrieben. Diese haben den Nachteil, dass die durch die Bestrahlung mit aktinischem Licht initiierte Polymerisation weitergeht, wenn die Bestrahlung unterbrochen wird. Daraus folgt, dass zum Erzielen Bilder guter Qualität die zweite Bestrahlungsstufe sofort vorgenommen werden muss. Dies beeinträchtigt die industrielle Anwendung dieses Verfahrens.

Die US-Patentschriften 4.288.527 und 4.352.723 beschreiben Acrylatmischungen, die durch UV-Bestrahlung und Wärme in beliebiger Reihenfolge oder gleichzeitig gehärtet werden, wobei feste Verbindungen erhalten werden, die sich als Ueberzüge, Dichtungen, Versiegelungsmittel oder Schutzmittel eignen. Die Mischungen können katalytische Mengen eines Pinakols, eines Photoinitiators und gegebenenfalls eines copolymerisierbaren Monomeren oder reaktiven Verdünnungsmittels enthalten. Diese Patentschriften beschreiben kein Verfahren, wonach eine flüssige Mischung zuerst durch Polymerisation oder Hitzeeinwirkung verfestigt und hernach ein Bild durch selektive UV-Bestrahlung erzeugt wird. Ausserdem wird in diesen Patentschriften nichts von einer Trennung zwischen der Hitzeeinwirkung und der UV-Bestrahlung ohne Verlust an Bildqualität erwähnt.

Es wurde nun gefunden, dass sich die erwähnten Nachteile der bekannten Verfahren vermeiden lassen durch die Verwendung von Mischungen enthaltend sowohl 1,2-Epoxid- als auch Acrylatgruppen in gleichen oder verschiedenen Molekülen.

Verbindungen enthaltend eine oder mehrere Epoxidgruppen und solche enthaltend eine oder mehrere Acrylatgruppen sind bekannt und im Handel erhältlich. Verbindungen enthaltend im gleichen Molekül sowohl mindestens eine 1,2-Epoxid- als auch mindestens eine Acrylatgruppe sind ebenfalls bekannt und zum Teil im Handel erhältlich, beispielsweise das Glycidylmethacrylat. Andere sind beispielsweise in der US-Patentschrift 3.450.613 beschrieben. Letztere erwähnt derartige bifunktionelle Verbindungen und ihre Herstellung aus einem Epoxyharz-Vorpolymerisat enthaltend mindestens zwei Epoxidgruppen und eine α,β-ungesättigte Carbonsäure, insbesondere Acryl- oder Methacrylsäure. Die erwähnte Patentschrift beschreibt auch die Härtung von solchen bifunktionellen Verbindungen durch Bestrahlung und nachfolgendem Erhitzen und ihre Verwendung als Kitt in der Optik.

Es wurde nun überraschenderweise gefunden, dass flüssige Gemische enthaltend eine Epoxy- und eine Acrylatgruppe ohne Lösungsmittel auf Trägern, wie kupferkaschierten Laminaten, thermisch zu einer festen, aber noch vernetzbaren Schicht polymerisiert werden können. Diese Schicht kann dann unter Vernetzung der belichteten Stellen bildmässig mit aktinischem Licht bestrahlt werden, wobei die nicht belichteten Stellen in Entwickler-Lösungen löslich bleiben.

Die Erfindung betrifft demnach ein Verfahren zur Bilderzeugung, wonach man

a) eine sich auf einem Träger befindliche Schicht aus einer flüssigen Mischung enthaltend

(A) ein hitze-aktivierbares latentes Polymerisationsmittel für 1,2-Epoxide und

(B) eine lichtempfindliche Verbindung, die im gleichen Molekül mindestens eine 1,2-Epoxidgruppe der Formel

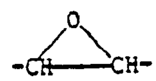

(I)

und mindestens eine ungesättigte Estergruppe der Formel

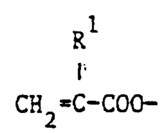

(II)

aufweist, worin $R^1$ H, Chlor, Brom oder $C_1$-$C_4$-Alkyl, insbesondere H oder Methyl, bedeutet, oder ein Gemisch aus

(C) einer mindestens eine 1,2-Epoxidgruppe der Formel (I) enthaltenden Verbindung und

(D) einer mindestens eine ungesättigte Estergruppe der Formel (II) enthaltenden Verbindung oder eine Mischung von Verbindungen (B) mit (C) und/oder (D) in der Weise erhitzt, dass sich die Schicht dadurch thermisch verfestigt und praktisch nichtklebrig wird, anschliessend

b) die verfestigte Schicht mit aktinischem Licht in einem vorgegebenen Muster bestrahlt, so dass sich die belichteten Stellen der Schicht vernetzen und

c) die nicht vernetzten Stellen der Schicht durch Behandeln mit einem Lösungsmittel entfernt.

Der Ausdruck « Bestrahlen in einem vorgegebenen Muster » umfasst sowohl das Belichten durch ein ein Bild aufweisendes transparentes Material als auch das Belichten mit einem computergesteuerten, ein Bild erzeugenden Laserstrahl.

Die Verbindung (C) enthält im allgemeinen eine oder zwei Gruppen der Formel I, und die Verbindung (D) enthält üblicherweise 2 oder mehr Gruppen der Formel II. Im allgemeinen haben die Verbindungen (B), (C) und (D) ein Molekulargewicht von mindestens 3 000. Vorzugsweise sind die Gruppen der Formel I entweder über die beiden angegebenen freien Bindungen direkt an einen cycloaliphatischen Ring gebunden oder sie bilden einen Bestandteil einer 2,3-Epoxypropylgruppe, direkt an ein O—, N— oder S-Atom gebunden.

Als Verbindungen (B) werden solche bevorzugt, die 1 oder 2 Gruppen der Formel I und 1-6 Gruppen der Formel II enthalten. Diese Gruppen können an aliphatische, aromatische, araliphatische, cycloaliphatische oder heterocyclische Moleküle gebunden sein.

Als typische Beispiele von Verbindungen der Formel (B) seien solche der untenstehenden Formeln genannt :

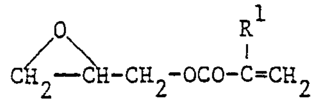

(III)

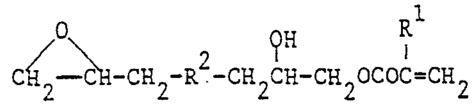

(IV)

oder

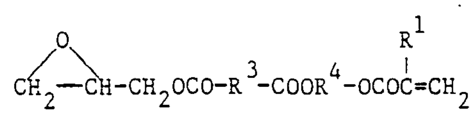
(V)

worin $R^1$ die angegebene Bedeutung hat, $R^2$ den Rest einer Di- oder Polyglycidylverbindung nach Entfernung von zwei Glycidylresten, —$OOCR^3COO$— den Rest einer Di- oder Polycarbonsäure und $R^4$ eine $C_1$-$C_6$-Alkylengruppe bedeuten. $R^2$ steht vorzugsweise für den Rest eines zweiwertigen Phenols, insbesondere eines Bisphenols, nach Entfernung der beiden phenolischen H-Atome, eines Glycolrestes nach Entfernung der beiden alkoholischen H-Atome oder eines Hydantoins nach Entfernung der beiden amidischen H-Atome. —$OOCR^3COO$— steht vorzugsweise für den Rest einer gesättigten oder ungesättigten aliphatischen oder aromatischen Dicarbonsäure, oder einer aromatischen Tri- oder Tetracarbonsäure, beispielsweise der Berstein-, Malon-, Malein-, Phthal-, Trimellit-, oder Pyromellitsäure.

$R^4$ steht vorzugsweise für einen Aethylen-, Propylen-, oder Butylenrest.

Geeignete Verbindungen (B) erhält man durch Einführung einer Gruppe der Formel (II) in eine Verbindung enthaltend bereits eine oder mehrere 1,2-Epoxygruppen oder umgekehrt, durch Einführung einer oder mehrerer 1,2-Epoxygruppen in eine Verbindung enthaltend eine oder mehrere Gruppen der Formel (II).

Eine geeignete Methode zur Einführung von Gruppen der Formel (II) in eine epoxidgruppenhaltige Verbindung, beispielsweise um eine Verbindung der Formel (IV) zu bilden, besteht in der Umsetzung von einer mindestens zwei Epoxidgruppen enthaltenden Verbindung mit weniger als der stöchiometrisch erforderlichen Menge einer Verbindung enthaltend sowohl eine Gruppe der Formel (II) als auch eine Carboxylgruppe, eine phenolische oder alkoholische Hydroxygruppe oder eine Amidgruppe die mit einer 1,2-Epoxidgruppe in der Weise zu reagieren vermögen, dass mindestens eine Gruppe der Formel (II) ins Molekül eintritt. Als dafür geeignete Polyepoxide kommen beispielsweise jene in Frage, die unten für die Herstellung der Verbindung (C) erwähnt werden.

Es versteht sich, dass nach diesem Verfahren keine 100 %ige Umsetzung zu Verbindungen enthaltend im gleichen Molekül eine 1,2-Epoxidgruppe der Formel (I) und eine Acrylatgruppe der Formel (II) erzielt wird. Das restliche Material enthält eine Mischung von unverändertem Ausgangsmaterial mit der ursprünglichen Anzahl Epoxidgruppen und Material, in welchem sämtliche Epoxidgruppen durch die Reste der Formel (II) ersetzt wurden. Solche Gemische können jedoch im vorliegenden Verfahren mit Erfolg eingesetzt werden.

Ein anderes Verfahren zur Herstellung der Verbindung (B), beispielsweise jener der Formel (III), durch Einführung einer oder mehrerer Epoxidgruppen in eine Verbindung enthaltend mindestens eine Gruppe der Formel (II) besteht darin, dass man die letztgenannte Verbindung, die zusätzlich mindestens eine alkoholische Hydroxylgruppe oder eine Carboxylgruppe aufweist, nach bekannten Methoden so behandelt, dass aus den Hydroxyl- oder Carboxylgruppen Glycidäther- oder -estergruppen entstehen. So kann z. B. die erwähnte Verbindung mit Epichlorhydrin in Gegenwart eines Chlorwasserstoffakzeptors, beispielsweise einer starken Base, wie NaOH und vorzugsweise eines Katalysators, wie einer quaternären Ammoniumverbindung, eines tertiären Amins, eines Uebergangsmetallsalzes, eines Thioäthers oder Sulfoniumsalzes, umgesetzt werden. Gewöhnlich wird ein Ueberschuss der theoretisch erforderlichen Menge Epichlorhydrin verwendet, wobei der Ueberschuss zugleich als Lösungsmittel für die Reaktion dient. Diese wird in der Regel bei Temperaturen zwischen 30-120 °C, vorzugsweise 40-65 °C, und unter vermindertem Druck zur Entfernung des bei der Reaktion entstandenen Wassers durchgeführt.

Ein geeignetes Verfahren zur Herstellung von Verbindung (B) der Formel (V) besteht darin, dass man eine hydroxylgruppenhaltige Verbindung enthaltend ausserdem eine Gruppe der Formel (II) durch Umsetzung mit einem Polycarbonsäureanhydrid in einem Halbester überführt, dessen freie Carboxylgruppe oder -gruppen nach dem oben angegebenen Verfahren glycidiert oder mit einer Verbindung enthaltend zwei oder mehrere Epoxidgruppen verestert werden, üblicherweise zwischen 60-120 °C in Gegenwart einer starken Base und eines Katalysators, beispielsweise einer quaternären Ammoniumverbindung oder eines Salzes eines Uebergangsmetalles.

Als Beispiele von Verbindung (B) seien genannt : Glycidylacrylat, Glycidylmethacrylat, 2-(4-Glycidyloxyphenyl)-2-(4-(3-acryloyloxy-2-hydroxypropoxy)-phenyl)-propan, 2-(4-(Glycidyloxyphenyl)-2-(4-(2-hydroxy-3-methacryloyloxy)-propoxy)-phenyl)-propan, 1-(2-Methacryloyloxyäthoxycarbonyl)-2,4- und-2,5-bis-(glycidyloxycarbonyl)-benzol, 1-(2-Acryloyloxyäthoxycarbonyl)-2,4- und-2,5-bis-(glycidyloxycarbonyl)-benzol, 2-Acryloyloxyäthoxy-glycidyl-succinat, 2-Methacryloyloxyäthoxy-glycidyl-succinat, 1-Glycidyl-3-(3-acryloyloxy-2-hydroxypropyl)-5,5-dimethylhydantoin, 1-Glycidyl-3-(2-hydroxy-3-methacryloyloxypropyl)-5,5-dimethylhydantoin, 1-Glycidyloxy-4-(3-acryloyloxy-2-hydroxypropyloxy)-butan, 1-Glycidyloxy-4-(2-hydroxy-3-methacryloyloxypropyloxy)-butan und das Reaktionsprodukt von 3,4-Epoxycyclohexylmethyl-3',4'-epoxycyclohexanecarboxylat mit 1 Aequivalent Acryl- oder Methacrylsäure.

Typische Beispiele für Verbindungen (C) sind Mono- oder Polyglycidylester, die dadurch erhältlich sind, dass man eine oder mehrere Carboxylgruppen pro Molekül enthaltende Verbindungen mit Epichlorhydrin oder Glycerin-Dichlorhydrin in Gegenwart von Alkali umsetzt. Derartige Glycidylester leiten sich bevorzugt ab von aliphatischen Mono- und Polycarbonsäuren, wie z. B. Essigsäure, Propionsäure, Bernsteinsäure, Glutarsäure, Adipinsäure, Pimelinsäure, Korksäure, Azelainsäure, Sebacinsäure oder dimerisierten oder trimerisierten Linolsäuren, von cycloaliphatischen Mono- und Polycarbonsäuren, wie Tetrahydrophthalsäure, Cyclohexancarbonsäure, 4-Methyltetrahydrophthalsäure, Hexahydrophthalsäure und 4-Methylhexahydrophthalsäure, und von aromatischen Mono- und Polycarbonsäuren, wie Benzoesäure, Phthalsäure, Isophthalsäure und Terephthalsäure.

Weitere Beispiele von Verbindungen (C) sind Mono- und Polyglycidyläther, die dadurch erhältlich sind, dass man eine oder mehrere freie alkoholische Hydroxylgruppen und/oder phenolische Hydroxylgruppen pro Molekül enthaltende Verbindungen in alkalischem Medium mit Epichlorhydrin oder in Gegenwart eines sauren Katalysators mit nachfolgender Alkalibehandlung umsetzt. Diese Aether können sich von acyclischen Alkoholen, wie Butanol oder anderen einwertigen Alkoholen mit 1-8 C-Atomen, Aethylenglykol, Poly(oxyäthylen)glykolen, Propan-1,2-diol, Poly(oxypropylen)glykolen, Propan-1,3-diol, Butan-1,4-diol, Poly(oxytetramethylen)glykolen, Glycerin, Pentaerythrit und Poly(epichlorhydrin), ableiten. Ferner können sie sich von einwertigen Phenolen, wie Phenol selbst, Kresol, Resorcin und von mehrkernigen Phenolen, wie Bis-(4-hydroxyphenyl)-methan, 4,4'-Dihydroxydiphenyl, Bis-(4-hydroxyphenyl)sulfon, 1,1,2,2-Tetrakis-(4-hydroxyphenyl)äthan, 2,2-Bis-(4-hydroxyphenyl)-propan (Bisphenol A), 2,2-Bis-(3,5-dibrom-4-hydroxyphenyl)-propan und Novolaken aus Aldehyden, wie Formaldehyd, mit Phenol, ableiten.

Weitere geeignete Verbindungen (C) sind Poly-(N-glycidyl)-Verbindungen, einschliesslich solcher, die durch Dehydrochlorierung von Reaktionsprodukten aus Epichlorhydrin und Aminen mit mindestens zwei Aminwasserstoffatomen, wie Anilin, n-Butylamin, erhalten werden, und Bis-(4-aminophenyl)-methan. Ferner eignen sich Triglycidylisocyanurat, N,N'-Diglycidylderivate von cyclischen Alkylenharnstoffen, wie Aethylenharnstoff, oder von Hydantoinen, wie 5,5-Dimethylhydantoin.

Es können auch Epoxidharze verwendet werden, bei denen einige oder alle Epoxidgruppen nicht endständig sind, wie z. B. Vinylcyclohexendioxid, Limonendioxid, Dicyclopentadiendioxid, 4-Oxa-tetracyclo-[6.2.1.$0^{2,7}$.$0^{3,5}$]undec-9-yl-glycidyläther, der Bis(4-oxytetracyclo-[6.2.1.$0^{2,7}$.$0^{3,5}$]undec-9-yl)-äther des Aethylenglykols, 3,4-Epoxycyclohexylmethyl-3',4'-epoxycyclohexancarboxylat und dessen 6,6'-Dimethylderivat, das Bis-(3,4-epoxycyclohexancarboxylat) des Aethylenglykols, 3-(3,4-Epoxycyclohexyl)-8,9-epoxy-2,4-dioxaspiro-[5,5]-undecan und epoxidierte Butadiene oder epoxidierte Copolymere von Butadien mit äthylenisch ungesättigten Verbindungen, wie Styrol und Vinylacetat. Gewünschtenfalls kann ein Gemisch verschiedener Verbindungen (C) eingesetzt werden.

Im erfindungsgemässen Verfahren besonders bevorzugte Verbindungen (C) sind 2,2,4-Trimethylpentylglycidyläther, Phenylglycidyläther, Butylglycidyläther, Diglycidyläther von zweiwertigen Phenolen, wie 2,2-Bis(4-hydroxyphenyl)propan und Bis(4-hydroxyphenyl)methan, oder von zweiwertigen Alkoholen, wie Butan-1,4-diol, sowie N,N'-Derivate von Hydantoinen, wie 1,3-Diglycidyl-5,5-dimethylhydantoin, und cycloaliphatische Epoxidharze, wie 3,4-Epoxycycloacrylmethyl-3',4'-epoxycyclohexancarboxylat.

Als Verbindungen (D) eignen sich Acrylate und Methacrylate einwertiger Alkohole, wie z. B. von 2-Methyoxyäthanol, Tetrahydrofurfurylalkohol oder Cyclohexanol, sowie ganz oder teilweise mit Acryl- oder Methacrylsäure veresterte aliphatische Glykole, wie Diäthylen-Dipropylen- oder Tetraäthylenglykole, und höherwertiger Polyole, wie Trimethylenpropan oder Pentaerythrit.

Weitere geeignete Verbindungen (D) sind 2-Hydroxypropylester, die durch Umsetzung von Acryl- oder Methacrylsäure mit eine oder mehrere Glycidylgruppen enthaltenden Verbindungen, insbesondere Mono- oder Polyglycidyläther von ein- oder mehrwertigen Alkoholen, Phenol, oder einem N-Glycylhydantoin erhältlich sind. Weitere geeignete Verbindungen (D) sind erhältlich durch Reaktion eines Di- oder Polyepoxides mit einem Aequivalent eines Adduktes eines Hydroxyalkylacrylates oder -methacrylates mit einem Anhydrid einer gesättigten oder ungesättigten Dicarbonsäure, beispielsweise der Bernstein-, Malein- oder Phthalsäure.

Typische Verbindungen (D) sind : 1,4-Bis(2-hydroxy-3-acryloxyloxypropoxy)butan, ein Poly(2-hydroxy-3-acryloyloxypropyl)äther eines Bisphenols oder eines Phenol-Formaldehyd-novlaks, 2,2-Bis(4-(2-hydroxy-3-(2-acryloyloxyäthoxy)succinyloxypropoxy)phenyl)propan, 1-(2-Hydroxy-3-acryloyloxypropoxy)-butan, -octan oder -decan, Bis(2-hydroxy-3-acryloyloxypropyl)-adipat, 2-Hydroxy-3-acryloxypropylpropionat, oder 3-Phenoxy-2-hydroxypropyl-acrylat sowie die entsprechenden Methacrylate.

Das Polymerisationsmittel (A) hat zweckmässig unterhalb einer gewissen « Schwellen-Temperatur » wenig oder keinen Einfluss auf die Epoxidgruppe in den Verbindungen (B) und (C), bewirkt jedoch eine rasche Polymerisation über den Epoxidring, wenn die Temperatur des Stoffgemisches die Schwellen-Temperatur überschreitet. Die Schwellen-Temperatur beträgt vorzugsweise mindestens 80 °C, so dass das Polymerisationsmittel (A) auf die Verbindungen (B) und (C) nur bei Temperaturen über 80 °C eine signifikante Hitze-Polymerisationswirkung ausübt. Bevorzugt wird die Schicht während 2 bis 60, vorzugsweise während 2 bis 40, und insbesondere während 2 bis 20 Minuten auf 100 bis 200 °C erhitzt.

Beispiele geeigneter Polymerisationsmittel (A) sind Bortrichlorid- und Bortrifluoridkomplexe, Chelate von Bordifluorid, Dicyandiamid oder Imidazolen, Mischungen aromatischer Oniumsalze, aromatischer Jodosylsalze, Metallhalogenidsäuren oder Metalloidhalogensäuren mit Katalysatoren beispielsweise Salzen oder Komplexen von d-Block-Uebergangsmetallen, Zinnsalzen, organischen Peroxiden oder aktivierten α-Hydroxyverbindungen, also Verbindungen, die eine an ein C-Atom gebundene Hydroxygruppe enthalten, das in α-Stellung zu einer aktivierenden Gruppe, wie einer Carbonylgruppe oder einem eine Hydroxygruppe enthaltenden C-Atom sitzt, wobei die Verbindungen beim Erhitzen freie

Radikale bilden.

Geeignete Bordifluorid-Chelate, wie z. B. Difluorbor-Acetoacetanilid, sind in der US-Patentschrift 3.424.699 beschrieben. Als Imidazole eignen sich beispielsweise 2-Methylimidazol, 2-Phenylimidazol, 1-Benzyl-2-methylimidazol und 1-Cyanoäthyl-2-methylimidazol. Geeignete Mischungen aromatischer Oniumsalze wie Jodonium- oder Sulfoniumsalze mit Katalysatoren sind in den US-Patentschriften 4.192.924 und 4.374.751 beschrieben.

Bevorzugte Polymerisationsmittel (A) sind Komplexe von Bortrichlorid mit tertiären Aminen oder von Bortrifluorid mit einem Triarylphosphin, mit Piperidin oder mit einem primären Amin, wobei die primären und tertiären Amine aliphatisch, cycloaliphatisch oder heterocyclisch sein können. Als Beispiele eines geeigneten Komplexes von Bortrichlorid mit einem tertiären Amin sei der Bortrichlorid-Trimethylamin-Komplex genannt ; weitere geeignete Komplexe von Bortrichlorid mit tertiären Aminen sind in der US-Patentschrift 3.784.647 beschrieben. Besonders bevorzugt ist der Bortrichlorid-Octyldimethylamin-Komplex. Geeignete Bortrifluorid-Komplexe sind z. B. solche mit Triphenylphosphin, Isophorondiamin, Benzylamin, Cyclohexylamin und Tetramethylhexamethylendiamin. Besonders bevorzugt ist der Bortrifluorid-Aethylamin-Komplex.

Als weitere bevorzugte Verbindungen (A) sind Mischungen von (a) Salzen enthaltend ein Diphenyljodosyl-Kation in welchem die Phenylgruppe durch $C_1$-$C_4$-Alkyl, Nitro- oder Halogen substituiert sein kann und als Anion $Sb(OH)F_5^{\ominus}$ $As_3F_6^{\ominus}$, $SbCl_6^{\ominus}$, $BiCl_6^{\ominus}$, $SbF_6^{\ominus}$, $SnCl_5^{\ominus}$, $FeCl_4^{\ominus}$, $BF_4^{\ominus}$, oder $PF_6^{\ominus}$, wobei die beiden letztgenannten besonders bevorzugt sind, und (b) einem Katalysator für das Jodosylsalz, wie Benzoylperoxid, Zinnchlorid, Ascorbinsäure, Pinakol, Benzpinakol, Zink-, Kobalt-, Chrom-, Eisen- oder insbesondere Kupfersalze, beispielsweise Kupferchlorid, -acetat oder -trichloracetat oder Komplexe dieser Metalle mit 1,3-Diketonen, wie Acetylaceton, Benzoylaceton, Acetessigester oder eine Mischung dieser Katalysatoren. Die Menge des Katalysators (b) liegt zweckmässig zwischen 10-150 Gew.-% des Diphenyljodosylsalzes. Letzere sind nach den von F. M. Beringer oder P. Bodlaender im J. Org. Chem. 1986, *33* S. 2981-4 beschriebenen Verfahren erhältlich.

Die Menge des Polymerisationsmittels (A) beträgt zweckmässig 1 bis 10 Gew.-%, vorzugsweise 2-5 Gew.-%, der Verbindung (B) und/oder (C).

Die Verbindungen (B), (C) und (D) können flüssig oder fest sein. Die Stoffgemische werden jedoch — wie oben erwähnt — in flüssiger Form auf das Trägermaterial appliziert. Die Viskosität des Stoffgemisches liegt bevorzugt zwischen 0,1 und 0,4 Pa · s. Um feste Materialien in eine flüssige Form zu bringen und den oben angegebenen gewünschten Viskositätsbereich ohne Zusatz von flüchtigen Lösungsmitteln zu erreichen, kann es erforderlich sein, Gemische von Verbindungen (B) und (C), (B) und (C) oder (B), (C) und (D) zu verwenden. Besonders vorteilhaft ist die Mitverwendung eines Monoepoxids als Epoxidgruppen aufweisende Verbindung (C), entweder allein oder im Gemisch mit anderen Epoxidgruppen aufweisenden Verbindungen (B) und (C). Besonders bevorzugte Monoepoxide sind n-Butyl-, Phenyl- und Isooctylglycidyläther.

Ausser den bereits erwähnten können die Mischungen noch andere photopolymerisierbare Monomere, wie z. B. Acrylsäure und Methacrylsäure enthalten. Auch Verbindungen enthaltend zwei oder mehrere primäre oder sekundäre alkoholische Hydroxylgruppen können den Mischungen zur Unterstützung der Polymerisation zugesetzt werden. Bevorzugte Polyhydroxyverbindungen sind solche mit einem Mol. Gew. von mindestens 100 insbesondere von über 500. Als beispiele seien genannt : Polyoxyalkylenglykole und -triole, wie Polyoxyäthylen-, Polyoxypropylen- und Polyoxytetramethylenglykole und -triole, Polyepichlorhydrine, hydroxyterminierte Polycaprolactone, Polymere von Hydroxyalkylacrylaten und -methacrylaten, Copolymere von Allylalkohol mit Vinylmonomeren, wie Styrol, Polyvinylalkohole, Hydroxypropylcellulose und hydroxylgruppenhaltige Polyvinylacetate.

Die Bestrahlung der photopolymerisierbaren Mischung erfolgt zweckmässig in Gegenwart eines Photopolymerisationskatalysators (Photoinitiators), d. h. einer Verbindung, die bei der Bestrahlung in einen angeregten Zustand übergeht, welcher zur Bildung freier Radikale führt, welche die Polymerisation einleiten.

Geeignete Photoinitiatoren sind α-halogenierte Acetophenone, wie 2,2,2-Trichlor-4'-tert.-butylacetophenon, Benzophenon, O-Alkoxycarbonylderivate von Benziloxim, 1-Phenylpropan-1,2-dion, wie Benzil-(O-äthoxycarbonyl)-α-monoxim und 1-Phenylpropan-1,2-dion-2-(O-äthoxycarbonyl)-oxim, Benzilketale, Mischungen von Phenothiazinfarbstoffen, wie Methylenblau, Chinoxalinen, wie Salze der 2-(m- oder p-Methoxyphenyl)-chinoxalin-6'- oder 7'-sulfonsäure mit Elektronenabgebern, wie Na-Benzolsulfinat oder anderen Sulfinsäuren und deren Salzen, Arsinen, Phosphinen oder Thioharstoff (Photoredoxsysteme). Benzoldimethylketal ist ein besonders bevorzugter Photoinitiator. Die Menge des Photoinitiators beträgt zweckmässigerweise 0,1-20, vorzugsweise 0,5-15 % vom Gesamtgewicht von (B) und/oder (C) oder (D).

Die flüssigen Stoffgemische können nach üblichen Methoden auf das Trägermaterial appliziert werden, z. B. durch Sprühen, Wirbelbeschichtung, Walzen, Kaskadenguss und vor allem Vorhangguss. Das Trägermaterial wird zweckmässig so beschichtet, dass eine Schichtdicke von 1 bis 250 μm erzielt wird. Als Trägermaterial kommen z. B. Kupfer, Aluminium oder andere Metalle, Papier, Kunstharze oder Glas in Betracht. Bei der Lichtvernetzungsstufe des erfindungsgemässen Verfahrens wird bevorzugt aktinisches Licht mit Wellenlängen von 200-600 nm verwendet. Geeignete Lichtquellen für aktinisches Licht sind beispielsweise Kohlelichtbögen, Quecksilberdampflampen, fluoreszenzlampen mit UV-Licht

emittierenden Phosphoren, Argon- und Xenonglühlampen, Wolframlampen und photographische Flutlichtlampen. Quecksilberdampflampen, besonders Sonnenlampen, Fluroeszenzsonnenlampen und Metallhalogenidlampen sind besonders geeignet. Die erforderliche Belichtungszeit hängt von verschiedenen Faktoren ab, wie z. B. der Art der verwendeten Verbindungen, der Art der Lichtquelle und dem Abstand der Lichtquelle von dem zu belichtenden Stoffgemisch. Geeignete Belichtungszeiten können vom Fachmann auf dem Gebiet der Photovernetzung leicht durch Versuche ermittelt werden.

Geeignete Lösungsmittel zum Entwickeln der Bilder können ebenfalls leicht durch Versuche ermittelt werden. In Betracht kommen z. B. Cyclohexanon, Trimethylcyclohexanon, 2-Aethoxyäthanol, 1,1,1-Trichloräthan, Chloroform und Gemische davon. Die Wirkung des Lösungsmittels muss gegebenenfalls durch leichtes Umrühren oder leichtes Bürsten unterstützt werden. Ist das Trägermaterial mit einem geeigneten elektrisch leitenden Metall, im allgemeinen Kupfer oder Silber, beschichtet, das in unmittelbarem Kontakt mit dem Stoffgemisch steht, so kann das nicht lichtvernetzte Polymer nach dem Belichten entfernt und so das Metall freigelegt werden. Derart freigelegtes Metall kann dann an den Nicht-Bildstellen unter Bildung einer gedruckten Schaltung mit Aetzflüssigkeiten, wie Eisen(III)chlorid- oder Ammoniumpersulfat-Lösungen, weggeätzt werden.

Die Erfindung wird in den folgenden Beispielen illustriet. Darin sind Teile und Prozente Gewichtsteile bzw. Gewichtsprozente.

Die in den Beispielen verwendeten Verbindungen werden wie folgt hergestellt :

Harz I

100 g 2,2-Bis(4-glycidyloxyphenyl)-propan mit einem Epoxidgehalt von 5,1 Aequivalenten/kg und 0,1 g 2,6-Di-tert.butyl-4-methylphenol werden zusammen gerührt und auf 100° erhitzt. Zu dieser Mischung gibt man nun langsam während 1 1/2 Stunden eine Mischung von 22,8 g Methacrylsäure, 0,05 Chromtrioctanoat und 0,2 g 2,6-Ditert.butyl-4-methylphenol. Hernach wird die Mischung während weiterer 3/4 Stunden gerührt, dann abgekühlt. Das erhaltene Produkt, bestehend aus einer Mischung von 2-(4-Glycidyloxyphenyl)-2-(4-(2-hydroxy-3-methacryloyloxypropoxy)phenyl)-propan, 2,2-Bis(4-glycidyloxyphenyl)-propan, und 2,2-Bis(4-(2-hydroxy-3-methacryloyloxypropoxy)phenyl)-propan, hat einen Epoxidgehalt von 2,23 Aequivalenten/kg.

Harz II

Dieses Harz stellt ein handelsübliches Glycidylmethacrylat, mit einem Epoxidgehalt von 7,0 Aequivalenten/kg dar.

Harz III

500 g 1,4-Diglycidyloxybutan mit einem Epoxidgehalt von 9,35 Aequivalenten/kg werden mit 0,5 2,6-Di-tert.butyl-4-methylphenol und 0,25 g Chrom-(III)-trioktanoat gemischt und zu dieser Mischung bei 100 °C während 1 1/2 Stunden unter Rühren 201,0 g Methacrylsäure und 1,0 g 2,6-Di-tert.butyl-4-methylphenol zugegeben. Nach weiteren 2 1/2 Stunden Rühren bei 100° erhält man ein Produkt, das eine Mischung von 1-Glycidyloxy-4-(2-hydroxy-3-methacryloyloxypropyloxy)-butan, 1,4-Diglycidyloxybutan, und 1,4-Bis-(2-hydroxy-3-methacryloyloxypropyloxy)-butan, mit einem Epoxidgehalt von 3,45 Aequivalenten/kg darstellt.

Harz IV

400 g 1,3-Diglycidyl-5,5-dimethylhydantoin mit einem Epoxidgehalt von 8,1 Aequivalenten/kg, wird mit 0,4 g 2,6-Di-tert.butyl-4-methylphenol und 0,2 g Chrom-(III)-trisoctanoat vermischt und die Mischung bei 100 °C unter Zugabe von 139,3 g Methacrylsäure und 0,8 g 2,6-Di-tert.-butyl-4-methylphenol während 1 1/2 Stunden gerührt. Hernach wird während 2 3/4 Stunden bei dieser Temperatur weitergerührt, worauf man eine Mischung von 1-Glycidyl-3-(2-hydroxy-3-methacryloyloxypropyl)-5,5-dimethyl-hydantoin, 1,3-Diglycidyl-5,5-dimethylhydantoin, und 1,3-Di-(2-hydroxy-3-methacryloyloxypropyl)-5,5-dimethylhydantoin, mit einem Epoxidgehalt von 2,78 g Aequivalenten/kg erhält.

Harz V

Dieses Harz stellt ein handelsübliches Glycidylacrylat mit einem Epoxidgehalt von 7,8 Aequivalenten/kg dar.

Harz VI

100 g eines Epoxidharzes auf Basis von 2,2-Bis(4-hydroxyphenyl)-propan mit einem Epoxidgehalt von 1,6 Aquivalenten/kg und 0,1 g 2,6-Di-tert.butyl-4-methylphenol werden zum Schmelzen erhitzt, gerührt und auf 130 °C erhitzt. Zu dieser Mischung gibt man während 30 Minuten eine Mischung von 10,7

g Acrylsäure, 0,05 g Chrom-(III)-trisoctanoat und 0,2 g 2,6-Di-tert.butyl-4-methylphenol. Hernach wird die Mischung während weiterer 2 Stunden bei 130 °C gerührt und abgekühlt. Das erhaltene Produkt hat einen Epoxidgehalt von 0,07 Aequivalenten/kg.

Harz VII

Eine Mischung enthaltend 192 g Trimellitsäureanhydrid, 130 g 2-Hydroxyäthylmethacrylat, 1 g Tetramethylammoniumchlorid und 0,3 g Hydrochinon wird während 2 Stunden auf 60° erhitzt. Nach dieser Zeit ist kein Anhydrid mehr vorhanden. Zu dieser Mischung gibt man 185 g Epichlorhydrin, erhitzt während 2 Stunden auf 90 °C, wonach der Epoxidgehalt auf 0 gesunken ist. Weitere 925 g Epichlorhydrin werden zugegeben und das Reaktionsgemisch bei 55-57 °C mittels eines Dean-Stark-Abscheiders unter vermindertem Druck erhitzt. Dann gibt man eine Lösung von 88 g NaOH in 88 g Wasser während 2 Stunden zu und erhitzt weitere 1 1/2 Stunden am Rückfluss. Es werden insgesamt 124 g Wasser abgeschieden. Die Mischung wird dann gekühlt, filtriet, mit 200 ml 10 %iger Natriumdihydrogenorthophosphatlösung und schliesslich zweimal mit 500 ml Wasser gewaschen. Nach dem Trocknen mit Magnesiumsulfat, welches abfiltriert wird, wird das überschüssige Epichlorhydrin durch Erhitzen auf 100 °C unter vermindertem Druck in einem Rotationsverdampfer entfernt. Man erhält eine Mischung von 1-(2-Methacryloyloxyäthoxycarbonyl)-2,4- und 2,5-Bis(glycidyloxycarbonyl)-benzol mit einem Epoxidgehalt von 3,36 Aequivalenten/kg (73 % der Theorie).

Harz VIII

100 g 3,4-Epoxycyclohexylmethyl-3',4'-epoxycyclohexancarboxylat mit einem Epoxidgehalt von 7,2 Aequivalenten/kg und 0,1 g 2,6-Di-tert.-butyl-4-methylphenol werden unter Rühren auf 80 °C erhitzt. Zu dieser Mischung gibt man während 30 Minuten eine Mischung von 25,9 g Acrylsäure 0,07 g Chrom-(III)-trisoctanoat und 0,2 g 2,6-Di-tert.-butyl-4-methylphenol. Hernach wird während weiteren 2 Stunden bei dieser Temperatur gerührt und abgekühlt.

Das erhaltene Produkt stellt eine Mischung von Verbindungen der Formel

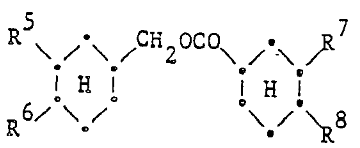

(VI)

dar, worin einerseits $R^5$ und $R^6$, und andererseits $R^7$ und $R^8$ mit den C-Atomen, denen sie zugeordnet sind eine Epoxidgruppe bilden, oder worin einer der Reste eine Hydroxylgruppe und der andere eine Acryloylgruppe bedeuten, wobei der Epoxidgehalt 2,4 Aequivalente/kg beträgt.

Harz IX

150 g Phenylglycidyläther mit einem Epoxidgehalt von 6,37 Aequivalenten/kg, 0,45 g Triphenylphosphin und 0,3 g 2,6-Di-tert.-butyl-4-methylphenol werden unter Rühren auf 100 °C erhitzt. Zu dieser Mischung werden 82,2 g Methacrylsäure während 1 Stunde zugegeben. Hernach wird die Mischung während 5 Stunden unter Rühren auf 100 °C erhitzt und dann abgekühlt. Man erhält eine Mischung von Phenylglycidyläther und 2-Hydroxy-3-methacryloyloxypropoxybenzyl mit einem Epoxidgehalt von 0,83 Aequivalenten/kg.

Harz X

Dieses Harz stellt ein handelsübliches Epoxidharz auf Basis eines hydrierten 2,2-Bis-(4-hydroxyphenyl)-propans mit einem Epoxidgehalt von 5,2 Aequivalenten/kg dar.

Harz XI

100 g eines epoxidierten Novolaks aus einem Phenol-Formaldehyd Novolak (Verhältnis P : F = 4,33 : 1) mit einem Epoxidgehalt von 6,23 Aequivalenten/kg und 0,1 g 2,6-Di-tert.butyl-4-methylphenol werden zum Schmelzen gebracht und unter Rühren auf 120 °C erhitzt. Zu dieser Mischung gibt man während 1 Stunde eine Mischung von 42,2 g Acrylsäure, 0,05 g Chrom-(III)-trisoctanoat und 0,2 g 2,6-Di-tert.-butyl-4-methylphenol. Dann wird die Mischung während 3 Stunden bei 120 °C gerührt bis zu einem Epoxidgehalt von 0,26 Aequivalenten/kg. Dann gibt man weitere 6,77 g epoxidierten Novolak und 0,025 g Chrom-(III)-trioctanoat zu. Die Mischung wird während 5 Stunden bei 120 °C weitergerührt und abgekühlt. Das Produckt weist einen Epoxidgehalt von nur 0,10 Aequivalent/kg auf.

Diphenyliodosyl-Hexafluorophosphat

Zu einer Lösung von 8 g NaOH in 200 ml Wasser gibt man bei 0 °C unter Rühren 23,6 g Jodoxybenzol. Es wird während 1 1/2 Stunden weitergerührt. Dann wird die Mischung filtriert und eine 10-%ige Lösung von Hexafluorophosphorsäure zum Filtrat gegeben bis die H-Ionenkonz. $10^{-4}$ mol · $l^{-1}$ beträgt. Dabei entsteht ein weisser Niederschlag, der abfiltriert, mit Wasser gewaschen und an der Luft getrocknet wird. Das erhaltene Produkt wird mit Aether extrahiert, um sämtliche Spuren von Jodbenzol zu entfernen, und schliesslich getrocknet. Die Ausbeute an Diphenyliodosylhexafluorphosphat vom Schmelzpunkt 128-130 °C beträgt 60 %.

Beispiel 1

Eine Mischung aus 40 Teilen 2,2-Bis-(4-(2-hydroxy-3-methacryloyloxypropoxy)-phenyl)-propan, 10 Teilen Tripropylenglykoldiacrylat, 50 Teilen Harz II, 2 Teilen Benzildimethylketal und 3 Teilen Bortrifluoridmonoäthylamin-Komplex wird als 20 µm dicke Schicht auf ein kupferkaschiertes Laminat aufgetragen. Man erhitzt während 40 Minuten in einem Ofen auf 120°, lässt abkühlen und bestrahlt die verfestigte Schicht während 3 Minuten durch ein Negativ ein mit einer 5 000 W Metallhalogenidlampe auf eine Distanz von 75 cm. Nach dem Entwickeln mit einer 10 : 1 Mischung von Toluol und Aceton erhält man ein gutes Bild.

Beispiel 2

50 Teile Harz I und 50 Teile Harz II werden mit 2 Teilen Benzildimethylketal und 2 Teilen Bortrifluorid-Monoäthylamin-Komplex als 30 µm dicke Schicht auf ein kupferkaschiertes Laminat aufgetragen. Man erhitzt während 5 Minuten lässt abkühlen und bestrahlt die verfestigte Schicht während 10 Sekunden durch ein Negativ mit einer 5 000 W Metallhalogenidlampe aus einem Abstand von 75 cm. Nach dem Entwickeln in 80° warmem Wasser unter leichtem Bürsten erhält man ein gutes Bild.

Beispiel 3

Man arbeitet wie in Beispiel 2, verwendet aber 45 Teile Harz I, 10 Teile Harz II, 10 Teile Harz III und 45 Teile Harz IV. Die flüssige Schicht wird während 10 Minuten auf 160 °C erhitzt, dann während 10 Sekunden bestrahlt wie in Beispiel 2. Die Entwicklung erfolgt unter Bürsten in Wasser.

Beispiel 4

Eine Mischung aus 50 Teilen 2,2-Bis-(4-(2-hydroxy-3-methacryloyloxypropoxy)-phenyl)-propan, 50 Teilen Phenylglycidyläther, 2 Teilen Benzildimethylketal und 3 Teilen Bortrifluorid-Aethylamin-Komplex werden als Schicht auf kupferkaschiertes Laminat aufgetragen. Man erhitzt während 40 Minuten in einem Ofen bei 120° und lässt dann erkalten. Die verfestigte Schicht wird während 10 Minuten durch ein Negativ und einer 5 000 W Metallhalogenidlampe bestrahlt. Nach dem Entwickeln in einer 10 : 2 Mischung von Toluol und Aceton erhält man ein Bild.

Beispiel 5

Eine Mischung aus 50 Teilen 2,2-Bis-(4-(2-hydroxy-3-methacryloyloxypropoxy)-phenyl)-propan, 50 Teilen Harz V, 2 Teilen Benzildimethylketal und 3 Teilen Bortrifluorid-Octyldimethylamin-Komplex werden als Schicht auf ein kupferkaschiertes Laminat aufgetragen. Man erhitzt während 40 Minuten in einem Ofen auf 120° und lässt erkalten. Die verfestigte Schicht wird während 5 Minuten durch ein Negativ mit einer 5 000 W Metallhalogenidlampe aus einer Entfernung von 75 cm bestrahlt. Nach der Entwicklung mit Aceton erhält man ein gutes Bild.

Beispiel 6

Eine Mischung aus 50 Teilen Harz VI, 50 Teilen 1,4-Diglycidyloxybutan, 2 Teilen Benzildimethylketal und 5 Teilen Bortrifluorid-Aethylamin-Komplex wird als 20 µm dicke Schicht auf ein kupferkaschiertes Laminat aufgetragen. Man erhitzt in einem Ofen auf 120° und lässt erkalten. Die verfestige Schicht wird während 15 Sekunden durch ein Negativ mit einer 5 000 W Metallhalogenidlampe aus einer Entfernung von 15 cm bestrahlt. Nach der Entwicklung mit einer 1 : 1 Toluol-Acetonmischung erhält man ein Bild.

Beispiel 7

Eine Mischung aus 50 Teilen Harz VI, 30 Teilen Harz II, 20 Teilen 1,4-Diglycidyloxybutan, 2 Teilen Benzildimethylketal und 2 Teilen Bortrifluorid-Aethylamin-Komplex wird als 25 µm dicke Schicht auf ein kupferkaschiertes Laminat aufgetragen. Man erhitzt während 20 Minuten in einem Ofen auf 120° und lässt erkalten. Die verfestigte Schicht wird während 24 Stunden durch ein Negativ mit einer 5 000 W

Metallhalogenidlampe aus einer Entfernung von 75 cm bestrahlt. Nach dem Entwickeln mit Aceton erhält man ein gutes Bild.

Beispiel 8

100 Teile Harz VII, 2 Teile Benzildimethylketal und 2 Teile Bortrifluorid-Aethylamin-Komplex werden als 20 µm dicke Schicht auf kupferkaschiertes Laminat aufgetragen. Man erhitzt während 10 Minuten in einem Ofen auf 120 °C und lässt erkalten. Die verfestigte Schicht wird während 3 Minuten durch ein Negativ mit einer 5 000 W Metallhalogenidlampe aus einer Entfernung von 75 cm bestrahlt. Nach dem Entwickeln mit Aceton erhält man ein Bild.

Beispiel 9

Eine Mischung aus 50 Teilen Harz VIII, 50 Teilen 3,4-Epoxycyclohexylmethyl-3',4'-epoxycyclohexancarboxylat, 2 Teilen Benzildimethylketal und 3 Teilen Bortrifluorid-Aethylamin-Komplex wird als 20 µm dicke Schicht auf ein kupferkschiertes Laminat aufgetragen. Man erhitzt während 5 Minuten in einem Ofen auf 120 °C und lässt abkühlen. Die verfestigte Schicht wird während 3 Minuten durch ein Negativ mit einer 5 000 W Metallhalogenidlampe aus einer Entfernung von 75 cm bestrahlt. Nach dem Entwickeln mit Cyclohexanon erhält man ein Bild.

Beispiel 10

Eine Mischung aus 50 Teilen Harz VI, 50 Teilen 1,4-Butanoldiglycidyläther, 2 Teilen Benzildimethylketal, 3 Teilen Diphenyljodosyl-hexafluorophosphat und 1 Teil Kupferacetylacetonat wird als 20 µm dicke Schicht auf ein kupferkaschiertes Laminat aufgetragen. Man erhitzt während 30 Minuten in einem Ofen auf 120 °C und lässt abkühlen. Die verfestigte Schicht wird während 30 Sekunden durch ein Negativ mit einer 5 000 W Metallhalogenidlampe aus einer Entfernung von 75 cm bestrahlt. Nach dem Entwickeln mit einer 1 : 1 Mischung von Toluol und Aceton erhält man ein Bild.

Beispiel 11

Eine Mischung aus 25 Teilen Harz IX, 75 Teilen 1-Glycidyl-3-methacryloyloxyäthyl-5,5-dimethylhydantoin, 2 Teilen Benzildimethylketal und 3 Teilen Bortrifluorid-Aethylamin-Komplex werden als 20 µm dicke Schicht auf kupferkaschiertes Laminat aufgetragen. Man erhitzt während 15 Minuten in einem Ofen auf 120 °C und lässt erkalten. Die verfestigte Schicht wird während 30 Sekunden durch ein Negativ mit einer 5 000 W Metallhalogenidlampe aus einer Entfernung von 75 cm bestrahlt. Nach dem Entwickeln mit einer 1 : 1 Mischung aus Toluol und Aceton erhält man ein Bild.

Beispiel 12

Eine Mischung aus 50 Teilen Harz VI, 50 Teilen Isooctylglycidyläther, 2 Teilen Benzildimethylketal und 5 Teilen Difluorboracetoacetanilid wird als 20 µm dicke Schicht auf ein kupferkaschiertes Laminat aufgetragen. Man erhitzt während 5 Minuten in einem Ofen auf 120 °C und lässt abkühlen. Die verfestigte Schicht wird während 30 Sekunden durch ein Negativ mit einer 5 000 W Metallhalogenidlampe aus einer Entfernung von 75 cm bestrahlt. Nach dem Entwickeln mit Cyclohexanon erhält man ein Bild.

Beispiel 13

Eine Mischung aus 100 Teilen Harz I, 2 Teilen Benzildimethylketal, 5 Teilen Diphenyljodosylhexafluorophosphat und 2,5 Teilen Kupferacetylacetonat werden als 20 µm dicke Schicht auf kupferkaschiertes Laminat aufgetragen. Man erhitzt während 25 Minuten in einem Ofen auf 120 °C und lässt erkalten. Die verfestigte Schicht wird während 30 Sekunden durch ein Negativ mit einer 5 000 W Metallhalogenidlampe aus einer Entfernung von 75 cm bestrahlt. Nach dem Entwickeln mit Aceton erhält man ein Bild.

Beispiel 14

Eine Mischung aus 50 Teilen Harz VI, 25 Teilen Harz IX, 25 Teilen Harz X, 2 Teilen Benzildimethylketal und 5 Teilen Difluorboracetoacetanilid wird als 20 µm dicke Schicht auf ein kupferkaschiertes Laminat aufgetragen. Man erhitzt während 10 Minuten in einem Ofen auf 120 °C und lässt abkühlen. Die verfestigte Schicht wird während 30 Sekunden durch ein Negativ mit einer 5 000 W Metallhalogenidlampe aus einer Entfernung von 75 cm bestrahlt. Nach dem Entwickeln mit Cyclohexanon erhält man ein Bild.

Beispiel 15

Eine Mischung aus 50 Teilen Harz VI, 15 Teilen 3,4-Epoxycyclohexylmethyl-3',4'-epoxycyclohe-

xancarboxylat, 35 Teilen Polyäthylenglycolmonomethacrylat, 2 Teilen Benzildimethylketal und 5 Teilen Difluoroboracetoacetanilid wird als 20 µm dicke Schicht auf ein kupferkaschiertes Laminat aufgetragen. Man erhitzt während 5 Minuten in einem Ofen auf 120 °C und lässt abkühlen. Die verfestigte Schicht wird während 20 Sekunden durch ein Negativ mit einer 5 000 W Metallhalogenidlampe aus einer Entfernung von 75 cm bestrahlt. Nach dem Entwickeln mit einer 1 : 1 Mischung aus Toluol und Aceton erhält man ein Bild.

Beispiel 16

Eine Mischung aus 50 Teilen Harz XI, 40 Teilen 3,4-Epoxycyclohexylmethyl-3',4'-epoxycyclohexancarboxylat, 10 Teilen Polyäthylenglycolmonomethacrylat, 2 Teilen Benzildimethylketal und 5 Teilen Difluorboracetoacetanilid wird als 20 µm dicke Schicht auf ein kupferkaschiertes Laminat aufgetragen. Man erhitzt während 10 Minuten in einem Ofen auf 120 °C und lässt abkühlen. Die verfestigte Schicht wird während 20 Sekunden durch ein Negativ mit einer 5 000 W Metallhalogenidlampe aus einer Entfernung von 75 cm bestrahlt. Nach dem Entwickeln mit Aceton erhält man ein Bild.

Beispiel 17

Eine Mischung aus 70 Teilen 1-Glycidyl-3-methacryloyloxyäthyl-5,5-dimethyldhydantoin, 2 Teilen Benzildimethylketal, 30 Teilen Polyalkylenglykolmonomethacrylat und 3 Teilen fein verteilter Kieserlerde wird als 20 µm dicke Schicht auf ein kupferkaschiertes Laminat aufgetragen. Man erhitzt während 20 Minuten in einem Ofen auf 120 °C und lässt abkühlen. Die verfestigte Schicht wird während 5 Minuten durch ein Negativ mit einer 5 000 W Metallhalogenidlampe aus einer Entfernung von 75 cm bestrahlt. Nach dem Entwickeln mit Aceton erhält man ein Bild.

Beispiel 18

Eine Mischung aus 70 Teilen 1-Glycidyl-3-methacryloyloxyäthyl-5,5-dimethylhydantoin, 30 Teilen Phenylglycidyläther, 2 Teilen Benzildimethylketal, 5 Teilen Bortrifluorid-Aethylamin-Komplex und 3 Teilen fein verteilter Kieselerde wird als 20 µm dicke Schicht auf ein kupferkaschiertes Laminat aufgetragen. Man erhitzt während 15 Minuten in einem Ofen auf 120 °C und lässt abkühlen. Die verfestigte Schicht wird während 5 Minuten durch ein Negativ mit einer 5 000 W Metallhalogenidlampe aus einer Entfernung von 75 cm bestrahlt. Nach dem Entwickeln mit einer 1 : 1 Mischung aus Toluol und Aceton erhält man ein Bild.

**Patentansprüche**

1. Verfahren zur Bilderzeugung, dadurch gekennzeichnet, dass man
a) eine sich auf einem Träger befindliche Schicht aus einer flüssigen Mischung enthaltend
(A) ein hitze-aktivierbares latentes Polymerisationsmittel für 1,2-Epoxide und
(B) eine lichtempfindliche Verbindung, die im gleichen Molekül mindestens eine 1,2-Epoxidgruppe der Formel

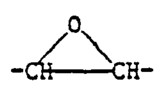
(I)

und mindestens eine ungesättigte Estergruppe der Formel

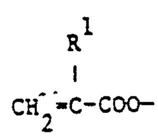
(II)

aufweist, worin $R^1$ H, Chlor, Brom oder $C_1$-$C_4$-Alkyl bedeutet, oder ein Gemisch aus
(C) einer mindestens eine 1,2-Epoxidgruppe der Formel (I) enthaltenden Verbindung und
(D) einer mindestens eine ungesättigte Estergruppe der Formel (II) enthaltenden Verbindung oder eine Mischung von Verbindungen (B) mit (C) und/oder (D) in der Weise erhitzt, dass sich die Schicht dadurch thermisch verfestigt und praktisch nichtklebrig wird, anschliessend
b) die verfestigte Schicht mit aktinischem Licht in einem vorgegebenen Muster bestrahlt, so dass sich die belichteten Stellen der Schicht vernetzen und
c) die nicht vernetzten Stellen der Schicht durch Behandeln mit einem Lösungsmittel entfernt.

2. Verfahren gemäss Anspruch 1, dadurch gekennzeichnet, dass die Gruppe der Formel I Teil eines

cycloaliphatischen Ringes oder einer 2,3-Epoxypropylgruppe ist, welch letztere direkt mit einem O-, N-, oder S-Atom verbunden ist.

3. Verfahren gemäss Anspruch 1, dadurch gekennzeichnet, dass $R^1$ in Formel II ein H-Atom oder eine Methylgruppe bedeutet.

4. Verfahren gemäss Anspruch 1, dadurch gekennzeichnet, dass Verbindung (B) 1-2 Gruppen der Formel I und 1-6 Gruppen der Formel II und ein Molgewicht von mindestens 3 000 aufweist.

5. Verfahren gemäss Anspruch 1, dadurch gekennzeichnet, dass Verbindung (B) die Formel

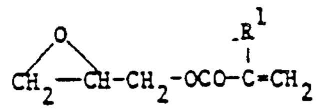
(III)

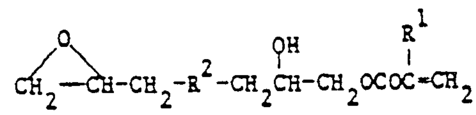
(IV)

oder

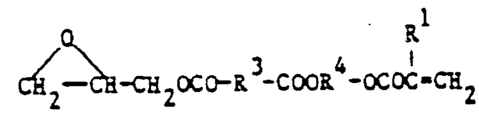
(V)

aufweist, worin $R^1$ die in Anspruch 1 angegebene Bedeutung hat, $R^2$ den Rest einer Di- oder Polyglycidylverbindung nach Entfernung von zwei Glycidylresten, $-OOCR^3COO-$ den Rest einer Di- oder Polycarbonsäure und $R^4$ eine $C_1$-$C_6$-Alkylengruppe bedeuten.

6. Verfahren gemäss Anspruch 5, dadurch gekennzeichnet, dass $R^2$ den Rest eines zweiwertigen Phenols nach Entfernung der beiden phenolischen H-Atome, eines Glykolrestes nach Entfernung der beiden alkoholischen H-Atome oder eines Hydantoins nach Entfernung der beiden amidischen H-Atome, $-OOCR^3COO-$ den Rest einer gesättigten oder ungesättigten aliphatischen oder aromatischen Dicarbonsäure, oder einer aromatischen Tri- oder Tetracarbonsäure, und $R^4$ einen Aethylen-, Propylen-, oder Butylenrest bedeuten.

7. Verfahren gemäss Anspruch 1, dadurch gekennzeichnet, dass Verbindung (C) eine oder zwei Gruppen der Formel I und ein Molgewicht von mindestens 3 000 aufweist.

8. Verfahren gemäss Anspruch 1, dadurch gekennzeichnet, dass Verbindung (C) einen Mono- oder Polyglycidylester, einen Mono- oder Polyglycidyläther, eine Poly-(N-glycidyl)-Verbindung oder ein Epoxidharz bedeutet, in welchem einige oder alle Epoxidgruppen nicht endständig sind.

9. Verfahren gemäss Anspruch 1, dadurch gekennzeichnet, dass die Verbindung (D) zwei oder mehrere Gruppen der Formel II und ein Molgewicht von mindestens 3 000 aufweist.

10. Verfahren gemäss Anspruch 9, dadurch gekennzeichnet, dass Verbindung (D) ein Acrylat oder Methacrylat eines einwertigen Alkohols, ein vollständig oder teilweise mit einer Acryl- oder Methacrylsäure verestertes aliphatisches Glykol oder Polyol, ein Ester, erhältlich durch Umsetzung einer Verbindung enthaltend eine oder mehrere Glycidylgruppen mit Acryl- oder Methacrylsäure, oder ein Ester, erhältlich durch Umsetzen eines Polyepoxides mit einem Aequivalent eines Adduktes eines Hydroxyalkylacrylates oder -methacrylates mit dem Anhydrid einer gesättigten oder ungesättigten Dicarbonsäure, bedeutet.

11. Verfahren gemäss Anspruch 1, dadurch gekennzeichnet, dass das Polymerisationsmittel erst bei Temperaturen über 80 °C einen deutlichen Polymerisationseffekt ergibt.

**Claims**

1. A process for the production of an image comprising

a) heating a layer, supported on a carrier, of a liquid composition containing

(A) a heat-activatable latent polymerising agent for 1,2-epoxides and

(B) a light-sensitive compound having in the same molecule at least one 1,2-epoxide group of formula

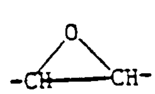
(I)

and at least one unsaturated ester group of formula

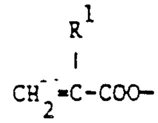
(II)

wherein $R^1$ is hydrogen, chlorine, bromine or $C_1$-$C_4$alkyl ; or a mixture of

(C) a compound containing at least one 1,2-epoxide group of formula (I) and

(D) a compound containing at least one unsaturated ester group of formula (II) ; or a mixture of compounds (B) and (C) and/or (D), such that the layer solidifies and becomes essentially non-tacky, and subsequently

b) exposing the solidified layer to actinic radiation in a predetermined pattern such that exposed parts of the layer are photopolymerised and

c) removing the non-photopolymerized parts of the layer by treatment with a solvent therefor.

2. A process according to claim 1, in which the group of formula I forms part of a cycloaliphatic ring or part of a 2,3-epoxypropyl group which is directly attached to an atom of oxygen, nitrogen or sulphur.

3. A process according to claim 1, in which $R^1$ in formula II is a hydrogen atom or a methyl group.

4. A process according to claim 1, in which compound (B) contains 1 or 2 groups of formula I and 1 to 6 groups of formula II and has a molecular weight of at least 3 000.

5. A process according to claim 1, in which compound (B) is of the formula

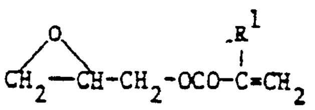

(III)

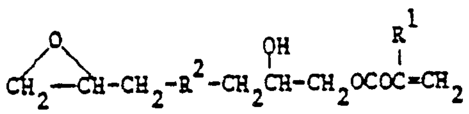

(IV)

or

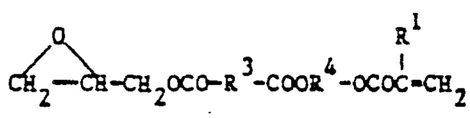

(V)

wherein $R^1$ is as defined in claim 1, $R_2$ is the radical of a di- or polyglycidyl compound after the removal of two glycidyl groups, —OOC$R^3$COO— is the radical of a di- or polycarboxylic acid, and $R^4$ is an alkylene group of 1 to 6 carbon atoms.

6. A process according to claim 5, in which $R^2$ is a dihydric phenol residue after removal of the two phenolic hydrogen atoms, a glycol residue after removal of the two alcoholic hydrogen atoms, or a hydantoin residue after removal of the two amidic hydrogen atoms, —OOC$R^3$COO— is the radical of saturated or unsaturated aliphatic or aromatic dicarboxylic acid or of an aromatic tri- or tetracarboxylic acid, and $R^4$ is an ethylene, propylene, or butylene group.

7. A process according to claim 1, in which compound (C) contains one or two groups of formula I and has a molecular weight of at least 3 000.

8. A process according to claim 1, in which compound (C) is a mono- or polyglycidyl ester, a mono- or polyglycidyl ether, a poly(N-glycidyl) compound, or an epoxy resin in which some or all of the epoxy groups are not terminal.

9. A process according to claim 1, in which compound (D) contains two or more groups of formula II and has a molecular weight of at least 3 000.

10. A process according to claim 9, in which compound (D) is an acrylate or methacrylate of a monohydric alcohol, a full or partial ester of acrylic or methacrylic acid with an aliphatic glycol or polyol, an ester formed by reaction of a compound containing one ore more glycidyl groups with acrylic or methacrylic acid, or an ester formed by reaction of polyepoxide with an equivalent amount of an adduct of a hydroxyalkyl acrylate or methacrylate with a saturated or unsaturated dicarboxylic acid anhydride.

11. A process according to claim 1, in which the polymerising agent has a significant heat-polymerising effect only at temperatures above 80 °C.

**Revendications**

1. Procédé pour la formation d'images, caractérisé en ce que :

a) on chauffe une couche se trouvant sur un support et obtenue à partir d'un mélange liquide contenant :

(A) un agent de polymérisation latent activable par la chaleur, pour les 1,2-époxydes et

(B) un composé sensible à la lumière, qui contient dans la même molécule au moins un groupe 1,2-époxy de formule :

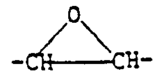

(I)

et au moins un groupe ester insaturé de formule :

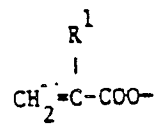

(II)

où $R^1$ représente H, 1 atome de chlore, 1 atome de brome ou un groupe alkyle en $C^1$-$C^4$, ou un mélange de :

(C) un composé contenant au moins un groupe 1,2-époxy de formule (I) et

(D) un composé contenant au moins un groupe ester insaturé de formule (II), ou un mélange des composés (B) avec (C) et/ou (D), de telle manière que la couche est ainsi durcie thermiquement, et n'est pratiquement pas collante, après quoi ;

b) la couche durcie est irradiée par une lumière actinique selon un dessin pré-établi, de telle manière que les zones éclairées de la couche soient réticulées et

c) on élimine les zones non réticulées de la couche par un traitement à l'aide d'un solvant.

2. Procédé selon la revendication 1, caractérisé en ce que les groupes de formule I représentent une partie d'un noyau cycloaliphatique ou d'un groupe 2,3-époxypropyle, ce dernier étant directement lié à un atome O—, N—, ou S—.

3. Procédé selon la revendication 1, caractérisé en ce que $R^1$ dans la formule II représente un atome H ou un groupe méthyle.

4. Procédé selon la revendication 1 caractérisé en ce que le composé (B) présente 1-2 groupes de formule I et 1-6 groupes de formule II et un poids moléculaire d'au moins 3 000.

5. Procédé selon la revendication 1, caractérisé en ce que le composé (B) présente la formule :

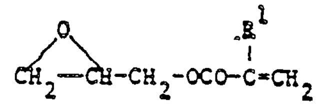

(III)

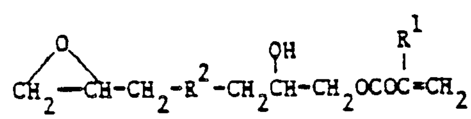

(IV)

ou

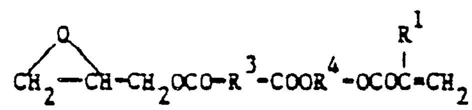

(V)

dans laquelle $R^1$ a la signification donnée dans la revendication 1, $R^2$ représente le reste d'un composé di- ou polyglycidylique après élimination de deux restes glycidyle, le reste —$OOCR^3COO$—, le reste d'un acide di- ou polycarboxylique, et $R^4$ représente un groupe alkylène en $C^1$-$C^6$.

6. Procédé selon la revendication 5, caractérisé en ce que $R^2$ représente le reste d'un phénol difonctionnel après élimination des deux atomes d'hydrogène phénolique, un reste de glycol après élimination des deux atomes d'hydrogène alcoolique ou un reste hydantoïne, après élimination des deux atomes d'hydrogène amidiques, —$OOCR^3COO$— le reste d'un acide dicarboxylique saturé ou insaturé, aliphatique ou aromatique, ou d'un acide tri- ou tétracarboxylique aromatique, et $R^4$ représente un reste éthylène, propylène ou butylène.

7. Procédé selon la revendication 1, caractérisé en ce que le composé (C) présente un ou deux groupes de formule I et un poids moléculaire d'au moins 3 000.

8. Procédé selon la revendication 1, caractérisé en ce que le composé (C) représente un ester mono- ou polyglycidylique, un éther mono- ou polyglycidylique, un composé poly- N-glycidylique ou une résine époxyde, dans laquelle quelques-uns des groupes époxy ou tous les groupes époxy ne sont pas terminaux.

9. Procédé selon la revendication 1, caractérisé en ce que le composé (D) présente deux groupes de formule II, ou plus de deux groupes de formuel II, et présente un poids moléculaire d'au moins 3 000.

10. Procédé selon la revendication 9, caractérisé en ce que le composé (D) représente un acrylate ou méthacrylate d'un alcool monofonctionnel, un polyol ou d'un glycol aliphatique totalement ou

partiellement estérifié par un acide acrylique ou méthacrylique, un ester obtenu par réaction d'un composé contenant un ou plusieurs groupes glycidyliques sur l'acide acrylique ou méthacrylique, ou un ester obtenu par réaction d'un polyépoxyde sur un équivalent d'un produit d'addition d'un hydroxyalkylacrylate ou d'un hydroxyalkylméthacrylate sur l'anhydride d'un acide dicarboxylique saturé ou insaturé.

11. Procédé selon la revendication 1, caractérisé en ce que l'agent de polymérisation ne produit un effet notable de polymérisation qu'à des températures supérieures à 80 °C.